# EUROPÄISCHE PATENTSCHRIFT

(11) **EP 0 852 066 B1**
(45) Veröffentlichungstag und Bekanntmachung des Hinweises auf die Patenterteilung: **16.08.2001**
(21) Anmeldenummer: 96938008.8
(22) Anmeldetag: 10.09.1996
(51) Int. Cl.: H01L 21/8247, H01L 27/115

(54) **VERFAHREN ZUM ERZEUGEN DER SOURCEBEREICHE EINES FLASH-EEPROM-SPEICHERZELLENFELDES**
PROCESS FOR GENERATING THE SOURCE REGIONS OF A FLASH-EEPROM STORAGE CELL FIELD
PROCEDE DE CREATION DES REGIONS SOURCE D'UNE ZONE DE CELLULE DE MEMOIRE FLASH EEPROM

(30) Priorität: 19.09.1995 DE 19534778
(43) Veröffentlichungstag der Anmeldung: 08.07.1998
(73) Patentinhaber: Infineon Technologies AG, 81669 München (DE)
(72) Erfinder: KERBER, Martin, D-81827 München (DE)
(74) Vertreter: Zedlitz, Peter, Dipl.-Inf.
(86) Internationale Anmeldenummer: DE9601696
(87) Internationale Veröffentlichungsnummer: WO9711489

(56) Entgegenhaltungen:
- WO-A-83/03167
- US-A- 4 513 397

## Beschreibung

Bei der Herstellung herkömmlicher Flash-EEPROM-Speicherzellen wird die Oberfläche eines Halbleitersubstrats lokal oxidiert, das heißt es werden Drain-, Kanal- und Sourcebereiche sowie die Sourceverbindungsbahnen freigelassen. Anschließend wird der Gatebereich thermisch oxidiert und auf dieses Gateoxid das Floating-Gate aufgebracht. Über dieses wird eine Isolationsschicht und darüber die Steuergate-Elektrode aufgebracht. Die Steuergate-Elektrode dient dabei als Wortleitung und verläuft über die Floating-Gates vieler nebeneinander liegender Speicherzellen. In der zum Verlauf der Wortleitungen senkrechten Richtung sind die Speicherzellen jeweils paarweise derart angeordnet, daß ihre Drainbereiche benachbart sind und sie jeweils einen gemeinsamen Drainanschluß haben. Die Sourceanschlüsse aller Speicherzellen sind mit Verbindungsbahnen parallel zu den Wortleitungen miteinander verbunden. Man bezeichnet diese Konfiguration als NOR-Schaltung.

Die Steuergate-Elektrode dient in einem nachfolgenden Herstellschritt als Maske für eine bezüglich dieser Elektrode selbstjustierte Dotierung der Drain- und Sourcegebiete. Der Abstand zwischen den Sourceverbindungsbahnen und den Wortleitungen, die zueinander parallel verlaufen, wird hierbei durch die Feldoxidkante sowie die Justierungenauigkeiten bei der Erzeugung der Wortleitungen bestimmt.

Zur Reduzierung des Abstands der Wortleitungen zweier benachbarter Speicherzellen ist es jedoch auch schon bekannt, diese zur selbstjustierten Implantation der zwischen ihnen liegenden Sourcegebiete zu verwenden.

Allerdings ist der Widerstand eines solchen Sourcegebiets und der Sourceverbindungsbahnen, die zwischen den Wortleitungen liegen, relativ hoch, so daß sich eine schlechte Lesecharakteristik der Speicherzelle ergibt.

Ein EEPROM, bei dem jede Zelle einen eigenen Source- und Drainbereich aufweist und ein Verfahren zu dessen Herstellung ist aus der US 4,513, 397 bekannt. Dort wird ebenfalls zunächst die Oberfläche des Substrats lokal oxidiert, um die Lage der einzelnen Speicherzellen zu definieren. Wortleitungen verlaufen über die Kanalbereiche benachbarter Speicherzellen und bilden die Steuergates. Unterhalb der Wortleitungen verläuft jeweils eine Polysiliziumbahn, die nur über einen Teilbereich der jeweiligen Kanalbereiche eine Unterbrechung aufweist, durch die hindurch eine zwischen den Wortleitungen und den Polysiliziumbahnen angeordnete, der Ladungspeicherung dienende schwebende Elektrode reicht. Die Wortleitungen und die Polysiliziumbahnen sind elektrisch miteinander verbunden.

Auch die DE 33 08 092 A1 zeigt eine Speicherzelle mit schwebender Gate-Elektrode, bei der unterhalb der schwebenden Gate-Elektrode eine Polysiliziumschicht angeordnet ist, die eine Ausnehmung aufweist, durch die hindurch die schwebende Gate-Elektrode ragt. Hier dient die Polysiliziumschicht jedoch als Steuergate-Elektrode.

Eine Speicherzelle mit schwebendem Gate mit den Merkmalen gemäß der DE 33 08 092 A1 und der US 4,513,397 offenbart auch die WO 83/03167. Auch hier werden die Steuergate-Elektroden durch entweder unterhalb der schwebenden Gate-Elektrode angeordneten Polysiliziumbahnen oder durch oberhalb und unterhalb der schwebenden Gate-Elektrode angeordnete Polysiliziumbereiche gebildet.

Die Aufgabe vorliegender Erfindung ist es somit, ein Verfahren zum Herstellen von Flash-Speicherzellen , das eine möglichst kleine Fläche pro Zelle und dabei eine gute Lesecharakteristik ermöglicht, anzugeben.

Die Aufgabe wird durch ein Verfahren gemäß Anspruch 1 gelöst.

Vorteilhafte Weiterbildungen der Erfindung sind in den Unteransprüchen angegeben.

In erfindungsgemäßer Weise wird zur Feldisolation auf das Halbleitersubstrat eine Siliziumoxid-Polysilizium-Siliziumoxid-Sandwich-Struktur aufgebracht. Zur Dotierung der Sourcebereiche und Sourceverbindungsbahnen wird eine Lackmaske aufgebracht, die die Bereiche zwischen den Wortleitungen eines jeweiligen Wortleitungspaares freiläßt. Die Lackmaske muß dabei nur einen Teil der Wortleitungen abdecken und braucht deshalb nicht exakt justiert zu werden. Durch HochenergieImplantation wird dann der Dotierstoff selbstjustiert zu den Wortleitungen implantiert. Im Fall, daß das Isolationssandwich zu dick ist, kann das Siliziumoxid oberhalb der Polysiliziumschicht vor der Implantation ebenfalls selbstjustiert isotrop geätzt werden.

In erfindungsgemäßer Weise bildet die Polysiliziumschicht des Isolationssandwichs zusammen mit dem Sourcegebiet eine relativ große Kapazität, die kurzzeitig Ladung aufnimmt und dadurch eine bessere Lesecharakteristik der Speicherzelle ergibt. Die Polysiliziumschicht des Isolationssandwichs ist dabei mit dem jeweiligen Wannenpotential verbunden.

Zur weiteren Verkleinerung der Fläche der Speicherzelle werden die die Kanalbereiche definierenden Gräben in der Isolationssandwichstruktur sehr schmal ausgeführt. Die hierfür nötige kleine Strukturweite wird in erfindungsgemäßer Weise nicht durch eine Fotolithographie, sondern durch Erzeugen einer Mikrostruktur als Ergebnis einer anisotropen Ätzung einer über einer Kante abgeschiedenen ersten Schicht und Entfernen der die Kante bildenden Struktur erzeugt.

Die Erfindung soll nachfolgenden anhand eines Ausführungsbeispiels mit Hilfe von Figuren näher beschrieben werden. Dabei zeigen:
- Figur 1: die Draufsicht auf eine in einem Halbleitersubstrat realisierte Flash-Speicherzelle,
- Figur 2: eine Querschnittsdarstellung entlang der Linie AA' der Figur 1,
- Figur 3 und Figur 4: die Querschnittdarstellung gemäß Figur 2 nach weiteren Prozeßschritten,
- Figuren 5A bis 5H: in schematischer Weise die erfindungsgemäße Abfolge eines Herstellprozesses des Kanals einer Flash-Speicherzelle bei einer Oxid-Polysilizium-Oxid-Sandwich-Isolation und
- Figur 6: den Querschitt durch eine Flash-Speicherzelle entlang der Linie BB' der Figur 1 mit einem erfindungsgemäßen schmalen Kanal in einer Oxid-Polysilizium-Oxid-Sandwich-Isolationsschicht.

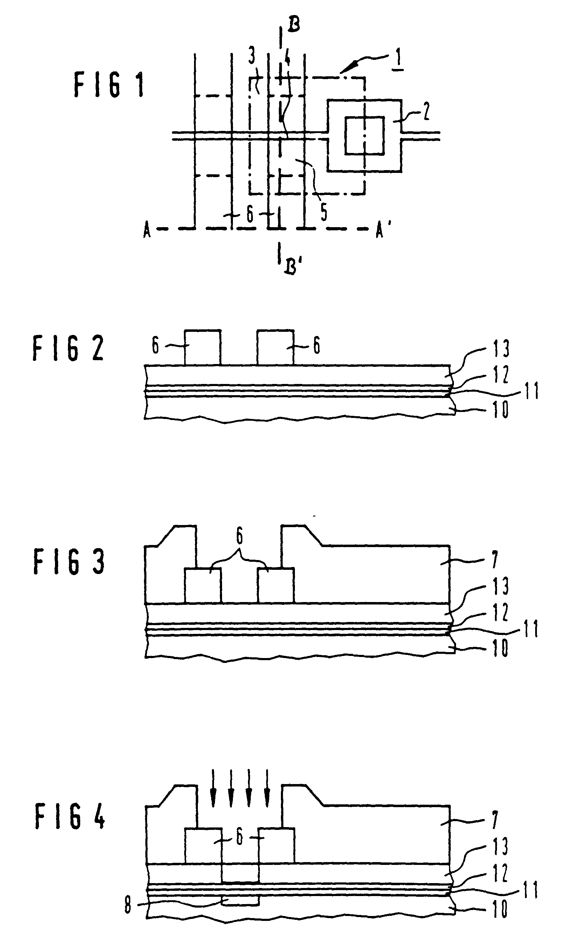

Die Draufsicht auf eine nach dem erfindungsgemäßen Verfahren hergestellte Flash-Speicherzelle 1 ist in Figur 1 dargestellt. Die Größe der Speicherzelle 1 ist hierbei durch eine strichpunktierte Linie angedeutet. In einem nicht näher bezeichneten Halbleitersubstrat sind ein Drainbereich 2 und ein Sourcebereich 3 durch Implantation von Dotierstoffen definiert. Zwischen dem Drainbereich 2 und dem Sourcebereich 3 verläuft ein Kanalbereich 4, der von einem strichliert dargestellten Floating-Gate überdeckt ist. Das Floating-Gate 5 ist dabei durch ein nicht näher bezeichnetes Gateoxid isoliert. Oberhalb des Floating-Gates 5 ist eine ebenfalls nicht dargestellte weitere Isolierschicht aufgebracht. Oberhalb dieser verläuft eine Steuergate-Elektrode 6, die gleichzeitig als Wortleitung 6 fungiert.

An die in Figur 1 dargestellte Flash-Speicherzelle 1 schließen sich in alle Richtungen direkt weitere Speicherzellen an. Die in Source-Kanal-Drain-Richtung einer Speicherzelle nebeneinander angeordneten Speicherzellen haben dabei jeweils entweder einen gemeinsamen Drainbereich 2 oder einen gemeinsamen Sourcebereich 3. In Figur 1 ist die Wortleitung 6 der benachbarten Speicherzelle mit gleichem Sourcebereich 3 dargestellt.

Figur 2 zeigt nun einen Querschnitt entlang der Linie AA' der Figur 1. Dort ist gezeigt, daß auf einem Halbleitersubstrat 10 eine Dünnoxidschicht 11 aufgebracht ist. Auf dieser Dünnoxidschicht 11 ist einen leitende Polysiliziumschicht 12 aufgebracht und oberhalb dieser eine Siliziumoxidschicht 13. Die leitende Polysiliziumschicht 12 hat eine abschirmende Wirkung. Auf der oberen Siliziumoxidschicht 13 sind die Wortleitungen 6 zweier benachbarter Speicherzellen schematisch dargestellt.

Im Bereich zwischen diesen Wortleitungen 6 sollen durch eine Dotierung im Halbleitersubstrat 10 die Sourcebereiche 3 und die zwischen den Sourcebereichen 3 verlaufenden Sourceverbindungsbahnen hergestellt werden.

Hierzu wird zunächst gemäß Figur 3 eine Fotolackmaske über die Wortleitungen 6 und die obere Siliziumoxidschicht 13 aufgebracht. Diese Fotolackschicht 7 wird unkritisch mittels Fotolithographie strukturiert und über den herzustellenden Sourcebereichen und Sourceverbindungsbahnen entfernt. Es ist hierbei unwesentlich, wie weit die Fotolackmaske 7 die Wortleitungen 6 überdeckt, so daß für die Strukturierung der Fotolackmaske 7 keine präzise Justierung der hierfür benötigten Belichtungsmaske erforderlich ist.

Durch Hochenergieimplantation von Dotierstoffen, wie dies in Figur 4 durch Pfeile angedeutet ist, werden dotierte Bereiche 8 im Halbleitersubstrat 10 erzeugt, die je nach Lage entweder die Source 3 oder aber Sourceverbindungsbahnen bilden. Falls die Isolationssandwichstruktur 11, 12, 13 zu dick ist, kann vor der Implantation des Dotierstoffs die obere Oxidschicht 13 ebenfalls selbstjustiert geätzt werden.

Das dotierte Gebiet 8 und die leitende Polysiliziumschicht 12 bilden eine Kapazität, die zu einer Ladungsspeicherung führt, wodurch die Lesecharakteristik der Speicherzelle deutlich verbessert wird, so daß der Einfluß der schlechten Leitfähigkeit des Dotiergebietes 8 in erfindungsgemäßer Weise verringert wird.

In den Figuren 5A bis 5H sind die einzelnen Schritte eines Herstellprozesses zum Erzeugen der Gräben für den Kanalbereich einer Flash-Speicherzelle auf einem Halbleitersubstrat dargestellt. Gleiche Schichten haben dabei gleiche Bezugszeichen.

Auf einem Halbleitersubstrat 100 ist eine Dünnoxidschicht 200 erzeugt worden. Darauf ist eine dotierte Polysiliziumschicht 300 abgeschieden worden, auf der eine Oxidschicht 400 erzeugt wurde. Oberhalb dieser Oxid-Polysilizium-Oxid-Sandwich-Isolationsschicht 200, 300, 400 ist nochmals eine Polysiliziumschicht 500 abgeschieden worden. Darüber wurde eine TEOS-(Tetra-Ethylen-ortho-Silan)-Schicht abgeschieden und mittels Fotolithographie strukturiert, so daß eine Struktur 700 mit einer steilen Kante entstand. Über diese Struktur 700 und die freie Fläche der Polysiliziumschicht 500 wurde eine Siliziumnitridschicht 600 abgeschieden. Dieser Zustand ist in Figur 5A dargestellt.

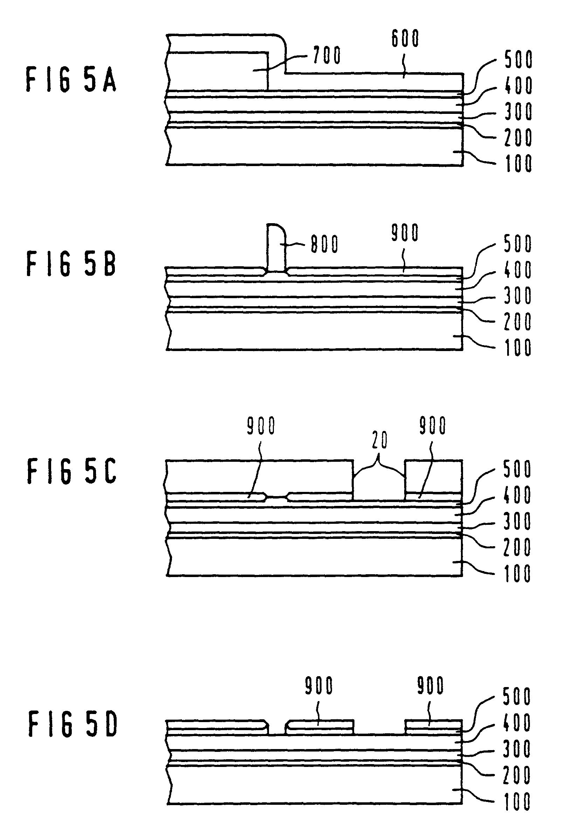

Die Siliziumnitridschicht 600 wird anisotrop zurückgeätzt, so daß nur an der Kante der Struktur 700 ein Rest 800 - ein sogenannter Spacer - dieser Siliziumnitridschicht 600 stehen bleibt. Anschließend wird die Struktur 700 entfernt und die darunter liegende Polysiliziumschicht 500 oxidiert. Der an der Kante der Struktur 700 zurückgebliebene Spacer 800 wirkt als Oxidationsbarriere, so daß nur um ihn herum die Polysiliziumschicht 500 oxidiert wird und eine Oxidschicht 900 um den Spacer 800 herum bildet. Dieser Zustand ist in Figur 5B dargestellt.

Anschließend wird der Spacer 800 entfernt. Dafür ist es nötig, daß er selektiv sowohl gegenüber dem Siliziumoxid als auch gegenüber dem Polysilizium geätzt werden kann. Diese Bedingung ist durch die Verwendung von Siliziumnitrid für die erste Schicht erfüllt. Es können aber auch anderer Materialien verwendet werden, wesentlich ist, daß sie gegeneinander selektiv geätzt werden können.

In Figur 5C ist nun dargestellt, wie gleichzeitig zu der kleinen Strukturweite in herkömmlicher Weise mittels einer Fotomaske 20 eine weitere Struktur erzeugt werden kann. Die Fotomaske 20 dient dazu, Bereiche in der Siliziumoxidschicht 900 zu ätzen. Anschließend wird die Fotomaske 20 wieder entfernt und mittels der als Ätzmaske dienenden Oxidschicht 900 das darunter liegenden Polysilizium 500 anisotrop geätzt. Dieser Zustand ist in Figur 5D dargestellt.

Wie in Figur 5E dargestellt ist, wird anschließend das Siliziumoxid 900 anisotrop geätzt, wodurch gleichzeitig die Oxidschicht 400 strukturiert wird.

Anschließend wird die Polysiliziumschicht 500 anisotrop geätzt, wodurch gleichzeitig die Polysiliziumschicht 300 strukturiert wird. Dieser Zustand ist in Figur 5F dargestellt.

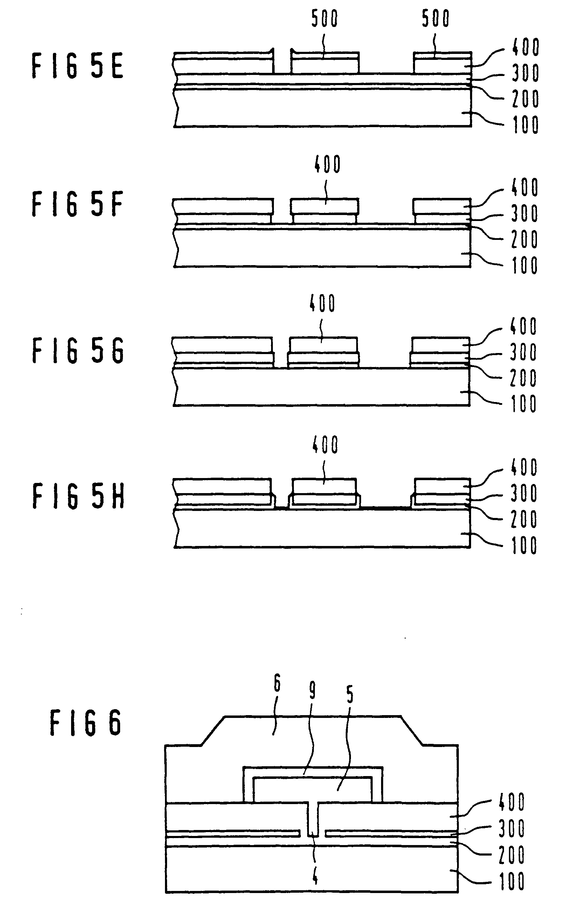

Wie in Figur 5G gezeigt ist, wird nun die Dünnoxidschicht 200 geätzt, wodurch auch die obere Oxidschicht 400 angeätzt wird. Anschließend wird, wie in Figur 5H dargestellt ist, das freigelegte Halbleitersubstrat 100 thermisch bis zu einer gewünschten Oxiddicke oxidiert. Dadurch werden auch die zuvor freigelegten Kanten der Polysiliziumschicht 200 mit einem Oxid abgedeckt und somit wieder isoliert.

In Figur 5H ist nun im rechten Teil eine "normale" Strukturweite dargestellt, wie sie durch einen herkömmlichen Fotolithographieschritt hergestellt werden kann und beispielsweise für die Drainbereiche der Flash-Speicherzellen benötigt wird und in dem linken Teil eine sehr kleiner Strukturweite, wie sie durch das erfindungsgemäße Verfahren realisiert werden kann und für den Kanalbereich der Flash-Speicherzellen besonders vorteilhaft ist.

Zur Realisierung einer Flash-Speicherzelle muß, wie in Figur 6 dargestellt ist, wobei für gleiche Teile gleiche Bezugszeichen wie in den vorherigen Figuren verwendet sind, eine leitfähige Schicht 5 als Floating-Gate aufgebracht werden, über der durch eine Isolationsschicht 9 getrennt eine weitere leitfähige Schicht 6 als Steuergate abgeschieden ist. Durch diese kleine Strukturweite 4 kann ein sehr schmaler Tunnelbereich erzeugt werden, wodurch ein großer Koppelfaktor möglich ist, der wiederum eine geringere Programmier- bzw. Löschspannung erlaubt. Außerdem wird durch diese kleine Kanalbreite die Speicherzelle kleiner.

## Patentansprüche

1. Verfahren zum Erzeugen von Source-Bereichen eines Flash-EEPROM-Zellenfeldes mit den Schritten:
a) Bilden einer Siliziumoxid-Polysilizium-Siliziumoxid-Schichtstruktur (11, 12, 13, 200, 300, 400) auf einem Halbleitersubstrat,
b) ein Kanalbereich (4) jeweils einer Zelle (1) wird durch Ätzen eines Grabens durch zumindest die obere Silizumoxidschicht (13) und die Polysiliziumschicht (12) der Schichtstruktur festgelegt,
c) durch thermische Oxidation wird eine Dicke der unteren Siliziumoxidschicht (11) der Zellen festgelegt und eine Isolation zwischen der Polysiliziumschicht (12) und dem Graben erreicht,
d) es wird jeweils eine in den Graben einer Zelle (1) reichende Floating-Gate-Elektrode (5) gebildet,
e) auf der Floating-Gate-Elektrode der Zellen (5) wird eine Isolationsschicht (9) erzeugt,
f) es werden auf der Isolationsschicht (9) verlaufende Wortleitungen (6) gebildet, die oberhalb der Floating-Gate-Elektroden (5) als Steuer-Gate-Elektroden wirken,
g) eine Photomaske (7) wird derart aufgebracht, daß sie die Wortleitungen (6) zumindest teilweise überdeckt und den Sourcebereiche (3, 8) bildenden Bereich zwischen den Wortleitungen (6) freiläßt,
h) durch Implantation eines Dotierstoffes in das Halbleitersubstrat werden die Sourcebereiche selbstjustiert zwischen den jeweiligen Wortleitungen (6) erzeugt.

2. Verfahren nach Anspruch 1, **dadurch gekennzeichnet,** daß vor dem Implantieren des Dotierstoffes die obere Siliziumoxidschicht (13, 400) der Schichtstruktur (11, 12, 13, 200, 300, 400) selbstjustiert bezüglich der Wortleitungen (6) entfernt wird.

3. Verfahren nach Anspruch 1 oder 2, **dadurch gekennzeichnet,** daß die die Kanalbereiche (4) definierenden Gräben sehr schmal sind und eine Ätzmaske für das Ätzen der Gräben durch Erzeugen einer Spacerstruktur (800) als Ergebnis einer anisotropen Ätzung einer über eine Kante abgeschiedenen zweiten Schicht (600) und Entfernen einer die Kante bildenden Struktur (700) erzeugt wird, wobei die Weite der Spacerstruktur (800) etwa gleich der Dikke der abgeschiedenen zweiten Schicht (600) ist und die Spacerstruktur (800) eine Oxidationsbarriere bei einer Oxidation einer unter der Spacerstuktur (800) und über der Siliziumoxid- Polysilizium - Siliziumoxid-Schichtstruktur liegenden ersten Schicht (500) ist, so daß die zur Spacerstruktur (800) lateral benachbarte durch Oxidieren der ersten Schicht erzeugte Oxidschicht (900) nach Entfernen der Spacerstruktur (800) als Ätzmaske für die darunter liegende erste Schicht (500) dient, wobei die Eigenschaften der Materialien der ersten und zweiten Schicht (500, 600) sowie der Oxidschicht (900) derart beschaffen sind, daß sie jeweils selektiv geätzt werden können.

4. Verfahren nach Anspruch 3, **dadurch gekennzeichnet,** daß die zweite Schicht (600) Siliziumnitrid und die erste Schicht (500) Polysilizium enthält.

5. Verfahren nach Anspruch 3 oder 4, **dadurch gekennzeichnet,** daß die erste Schicht (500) auf die Siliziumoxid-Polysilizium-Siliziumoxid-Schichtstruktur (11, 12, 13, 200, 300, 400) aufgebracht ist.

6. Verfahren nach Anspruch 3 bis 5, **dadurch gekennzeichnet,** daß eine jeweils oberste Schicht als Ätzmaske für eine darunterliegende Schicht verwendet wird.

## Claims

1. Process for producing source regions of a flash EEPROM cell array, with the steps:
a) forming a silicon oxide/polysilicon/silicon oxide layer structure (11, 12, 13, 200, 300, 400) on a semiconductor substrate,
b) a channel region (4) is established for each cell (1) by etching a trench through at least the upper silicon oxide layer (13) and the polysilicon layer (12) of the layer structure,
c) by thermal oxidation, a thickness is established for the lower silicon oxide layer (11) of the cells and insulation is achieved between the polysilicon layer (12) and the trench,
d) in each case a floating-gate electrode (5) extending into the trench of a cell (1) is formed,
e) an insulation layer (9) is produced on the floating-gate electrode of the cells (5),
f) word lines (6), acting above the floating-gate electrodes (5) as control-gate electrodes, are formed on the insulation layer (9),
g) a photomask (7) is applied in such a way that it at least partly covers the word lines (6) and leaves exposed the region between the word lines (6) which forms the source regions (3, 8),
h) the source regions are produced with self-alignment between the respective word lines (6) by implanting a dopant in the semiconductor substrate.

2. Process according to Claim 1, characterized in that the upper silicon layer (13, 400) of the layer structure (11, 12, 13, 200, 300, 400) is removed with self-alignment with respect to the word lines (6) before the dopant is implanted.

3. Process according to Claim 1 or 2, characterized in that the trenches which define the channel regions (4) are very narrow, and an etching mask for etching the trenches is produced by producing a spacer structure (800) as the result of anisotropic etching of a second layer (600) deposited over an edge and removing a structure (700) forming the edge, the width of the spacer structure (800) being approximately equal to the thickness of the deposited second layer (600), and the spacer structure (800) being an oxidation barrier during oxidation of a first layer (500) lying below the spacer structure (800) and above the silicon oxide/polysilicon/ silicon oxide layer structure, so that after the spacer structure (800) has been removed, the oxide layer (900), produced by oxidation of the first layer, laterally next to the spacer structure (800) acts an etching mask for the underlying first layer (500), the properties of the materials of the first and second layers (500, 600), and of the oxide layer (900), being such that they can each be etched selectively.

4. Process according to Claim 3, characterized in that the second layer (600) contains silicon nitride and the first layer (500) contains polysilicon.

5. Process according to Claim 3 or 4, characterized in that the first layer (500) is applied to the silicon oxide/polysilicon/silicon oxide layer structure (11, 12, 13, 200, 300, 400).

6. Process according to Claim 3 to 5, characterized in that a respective top layer is used an etching mask for an underlying layer.

## Revendications

1. Procédé pour produire des régions de source d'un champ de cellules flash EEPROM
comportant les étapes:
a) formation d'une structure (11, 12, 13, 200, 300, 400) en sandwich oxyde de silicium-polysilicium-oxyde de silicium sur un substrat semi-conducteur,
b) définition d'une région (4) de canal chaque fois d'une cellule (1) par attaque chimique ménageant un sillon passant au moins par la couche (13) d'oxyde de silicium supérieure et la couche (12) de polysilicium de la structure en couches,
c) par oxydation thermique, on fixe une épaisseur de la couche (11) inférieure d'oxyde de silicium des cellules et on obtient une isolation entre la couche (12) en polysilicium et le sillon,
d) on forme chaque fois une électrode (5) de grille flottante arrivant dans le sillon d'une cellule (1),
e) on produit une couche (9) isolante sur l'électrode de grille flottante de cellule (5),
f) on forme des lignes (6) de transmission de mots qui s'étendent sur la couche (9) isolante et qui agissent au-dessus des électrodes (5) de grille flottante comme électrodes de grille de commande,
g) on dépose un masque (7) photosensible de telle manière qu'il recouvre au moins partiellement les lignes (6) de transmission de mots et dégage la région entre les lignes (6) de transmission de mots formant les régions (3, 8) de source,
h) on produit par implantation d'une substance dopante dans le substrat semi-conducteur les régions de source de manière auto-ajustée entre les lignes (6) de transmission de mots associées.

2. Procédé suivant la revendication 1, caractérisé en ce que, avant l'implantation de la substance dopante, on enlève la couche (13, 400) supérieure d'oxyde de silicium de la structure (11, 12, 13, 200, 300, 400) en couches de manière auto-ajustée par rapport aux lignes (6) de transmission de mots.

3. Procédé suivant la revendication 1 ou 2, caractérisé en ce que les sillons définissant les régions (4) de canal sont très étroits et en ce qu'un masque d'attaque chimique pour l'attaque chimique des sillons est produit en produisant une structure (800) de spacer comme résultat d'une attaque chimique anisotrope d'une deuxième couche (600) déposée sur un bord et d'un enlèvement d'une structure formant le bord, la largeur de la structure (800) de spacer étant à peu près égale à l'épaisseur de la deuxième couche (600) déposée et la structure (800) de spacer étant une barrière d'oxydation lors d'une oxydation d'une première couche (500) se trouvant en-dessous de la structure (800) de spacer et au-dessus de la structure en couche oxyde de silicium-polysilicium-oxyde de silicium, si bien que la couche (900) d'oxyde voisine latéralement de la structure (800) de spacer et produite par oxydation de la première couche sert, après enlèvement de la structure (800) de spacer, de masque d'attaque chimique pour la première couche (500) qui se trouve en-dessous, les propriétés des matériaux de la première et de la deuxième couche (500, 600) ainsi que de la couche (900) d'oxyde étant telles qu'elles peuvent être attaquées chimiquement de manière sélective.

4. Procédé suivant la revendication 3, caractérisé en ce que la deuxième couche (600) contient du nitrure de silicium et la première couche (500) du polysilicium.

5. Procédé suivant la revendication 3 ou 4, caractérisé en ce que la première couche (500) est déposée sur la structure (11, 12, 13, 200, 300, 400) en couches oxyde de silicium-polysilicium-oxyde de silicium.

6. Procédé suivant la revendication 3 à 5, caractérisé en ce que l'on utilise chaque fois la couche du dessus comme masque d'attaque chimique pour une couche sous-jacente.
